Europäisches Patentamt

European Patent Office

Office européen des brevets

(11) Publication number: **0 218 308**
**B1**

# EUROPEAN PATENT SPECIFICATION

(45) Date of publication of patent specification: **15.03.89**

(21) Application number: **86201854.6**

(22) Date of filing: **06.01.84**

(51) Int. Cl.⁴: **B 62 D 15/02,** B 62 D 5/00

(60) Publication number of the earlier application in accordance with Art. 76 EPC: **0 115 381**

(54) Apparatus for detecting the angular position und angular velocity of a rotatable member and a method of assembling the apparatus.

(30) Priority: **29.01.83 JP 11958/83**

(43) Date of publication of application:
**15.04.87 Bulletin 87/16**

(45) Publication of the grant of the patent:
**15.03.89 Bulletin 89/11**

(84) Designated Contracting States:
**DE FR GB IT**

(56) References cited:
**DE-A-3 106 088**
**GB-A-1 417 788**
**GB-A-2 024 122**
**US-A-3 894 232**
**US-A-4 117 320**
**US-A-4 297 573**
**US-A-4 317 032**
**US-A-4 389 902**

(73) Proprietor: **TOYOTA JIDOSHA KABUSHIKI KAISHA**
**1, Toyota-cho Toyota-shi**
**Aichi-ken 471 (JP)**

(72) Inventor: **Hoshino, Shigeru**
**161 Banchi 1-Chome, Ohbayashi-cho**
**Toyota-shi Aichi-ken (JP)**
Inventor: **Miyata, Hiroshi**
**Dai 2 Ekaku Apart. B917, 56 Banchi 2-Chome**
**Ekakushinmachi Toyota-shi Aichi-ken (JP)**

(74) Representative: **Ben-Nathan, Laurence Albert et al**
**Urquhart-Dykes & Lord 91 Wimpole Street**
**London W1M 8AH (GB)**

## Description

The present invention relates to an apparatus for detecting an angular position and an angular velocity of a rotatable member and a method of assembling it, and particularly to a steering sensor for detecting a steering angle and a steering angular velocity.

Heretofore, an apparatus for detecting a steering angle and a steering angular velocity is generally known, comprising a disc mounted on a steering shaft, and a sensor secured to a stationary steering column tube. The present applicants have described an invention concerning the way in which the sensor is mounted, in a separate Patent Application. The disc is designed to be rotated with the steering shaft, and has a number of small holes which are concentrically located therein. The sensor has a light emitting element and a light receiving element, which are located on opposite sides of the disc at positions opposite the series of holes in the disc. When the steering shaft is rotated by a driver, the disc rotates with the steering shaft. In this condition, the light transmitted from the light emitting element to the light receiving element is interrupted by the rotation of the disc. The degree of the interruption is proportional to the number of the rotations of the disc. The degree of the interruption is converted to an electric pulse, and thereafter the steering angle and a steering angular velocity are calculated from the electric pulse.

It is quite difficult to assemble the disc and the sensor with a high degree of accuracy. Further, there is the possibility of adversely affecting the thin disc by contact of the thin disc with the light emitting element or the light receiving element during assembly in the steering system.

GB—A—1,417,788 describes an apparatus for generating electrical pulses for each revolution of a shaft, which has the features of the preamble of Claim 1.

The present invention was made in view of the foregoing background art. It is an object of this invention to provide an improved apparatus for detecting a steering angle and an angular velocity of a rotatable part of a steering system to overcome or minimize the aforesaid disadvantages of the known detecting apparatus whereby correct assembly is facilitated.

The invention provides an apparatus for detecting the angular position and angular velocity of a rotatable member, comprising a disc mounted on and rotatable with the rotatable member, the disc having a number of holes located around the circumference thereof, a fixed member, a sensor secured to the fixed member and having positioned on respective opposite sides of the disc, a light emitting means and light receiving means at locations opposite said holes in the disc, wherein the disc projects radially from the rotatable member towards the sensor by a distance, and the sensor is provided with extensions in which said light emitting means and said light receiving means are located, respectively, characterized in that there is provided a holder secured to the outer periphery of the steering shaft, the holder having the disc secured thereto at a central position along the length of the holder, in that the holder comprises a first side wall extending towards the sensor, a second side wall extending towards the sensor in a parallel relationship with the first side wall, the side walls being spaced apart at a distance $(2L_3)$, and a tubular portion which connects the first side wall and the second side wall, the disc being secured to the holder centrally of the tubular portion, and in that each of said extensions of the sensor have a width $(L_2)$, and they are spaced apart by a distance $(L_1)$, wherein the following relationship exists:—

$$L_1+L_2>L_3$$

The invention provides also a method of assembling the sensor of claim 1.

The method steps are set on in claim 6.

The above object, features and advantages of the present invention will become more apparent from the following description of a preferred embodiment taken in conjunction with the accompanying drawings, in which:—

Fig. 1 is a perspective view of a steering system provided with an apparatus according to the present invention;

Fig. 2 is a perspective view of a steering shaft provided with detecting means according to the present invention;

Fig. 3 is an enlarged partial cross-sectional view of the embodiment of the present invention;

Fig. 4 is a partial cross-sectional view taken along the line IV—IV in Fig. 3;

Fig. 5 is a reduced partial cross-sectional view taken along the line V—V in Fig. 2;

Fig. 6 is a cross-sectional view taken along the line VI—VI of Fig. 5;

Figs. 7(a), (b), (c) and (d) are views which illustrate the assembling steps of the disc and the sensor according to the present invention; and

Fig. 8 is a cross-sectional view which illustrates the relation between the sensor and the disc according to the present invention.

The present invention is described in detail with reference to the accompanying drawings which illustrate an embodiment of the present invention.

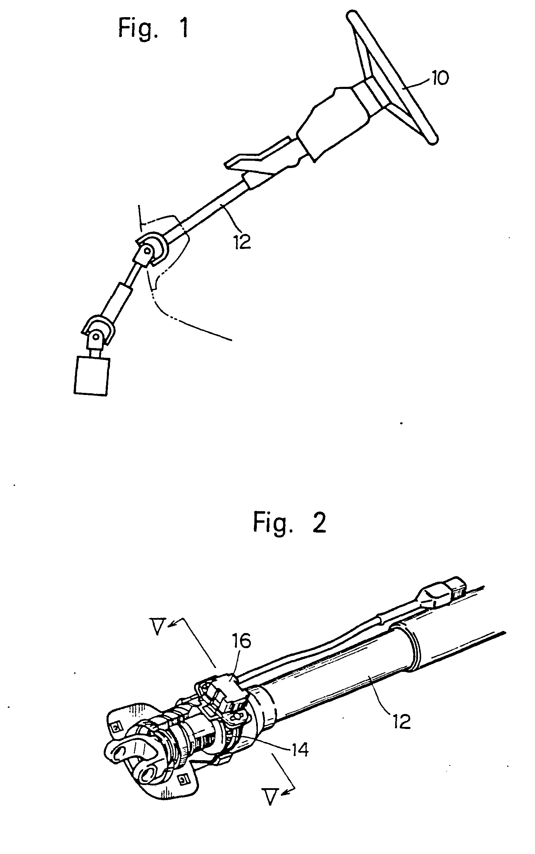

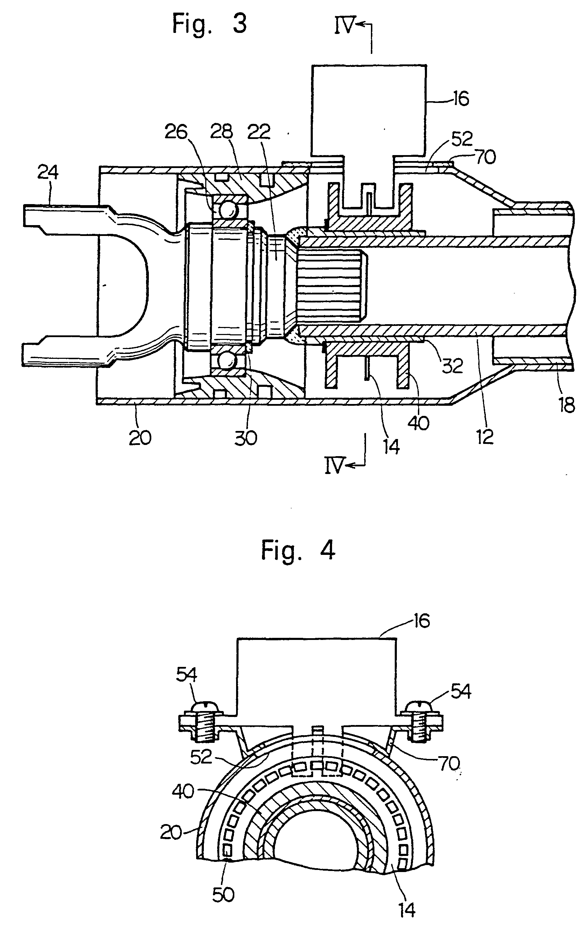

Fig. 1 shows a perspective view of a steering system provided with an apparatus according to the present invention. The rotational movement of a steering wheel 10 is transmitted through a steering shaft 12 to wheels (not shown in drawings). The perspective view of the steering shaft 12 according to the present invention is shown in Fig. 2. A disc 14, which includes a number of small holes concentrically located therein, is mounted on the outer periphery of the steering shaft 12. A sensor 16 is located at the outer side of the disc 14, and is secured to a steering column tube 18. Fig. 3 shows an enlarged detailed cross-sectional view of the apparatus according to the present invention.

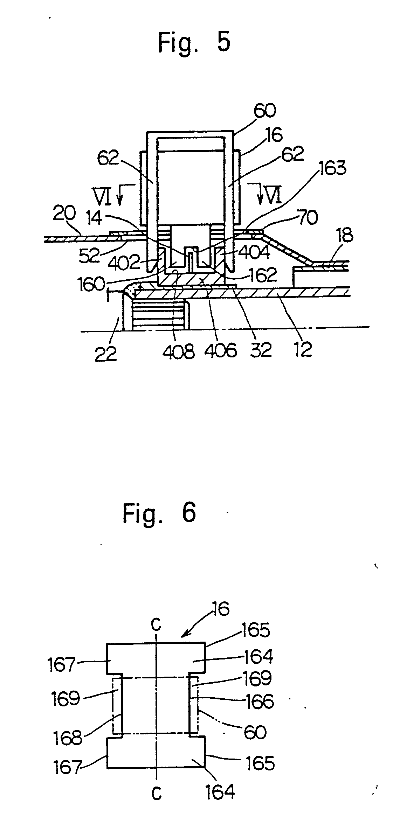

The steering column tube 18 extends downward (to the left in Fig. 3), and an enlarged lower steering column tube 20 is secured to the lower portion of the steering column tube 18. The steering shaft 12 is inserted into the inside of the steering column tube 18. The upper end of the steering shaft 12 is connected with the steering wheel 10. The lower part of the steering shaft 12 extends into the inside of the lower steering column tube 20. The lower end of the steering shaft 12 is fixed by welding to a shaft portion 22 of a yoke 24. A lower bearing 26 is provided on the outer periphery of the shaft portion 22 of the yoke 24. The lower bearing 26 is secured through a retainer 28 to the inner face of the lower steering column tube 20. A snap ring 30, provided on the outer periphery of the shaft portion 22 of the yoke 24, prevents the lower bearing 26 from slipping out. A collar 32 fits into the outer periphery of the steering shaft 12 and is welded to the steering shaft 12. A holder 40 is press fitted onto the outer periphery of the collar 32. The holder 40 has a U-shaped cross-sectional form. The holder 40 is to hold the disc 14 thereon. Figs. 5 through 8 illustrate the detailed structure of the holder 40. The holder 40 has side walls 402 and 404, and a tubular portion 406 which connects the side walls 402 and 404. The disc 14 is secured to the longitudinal central point of the outer surface 408 of the tubular portion 406. The disc 14, as shown in Fig. 4, includes a number of small holes 50, which are of the same form and are positioned concentrically with respect to the axis of the disc 14 at regularly spaced intervals. The lower steering column tube 20 has an aperture 52 at a position which faces the holder 40. The aperture 52 is square. The lower portion of the sensor 16 extends through the aperture 52 into the inside of the lower steering column tube 20. The sensor 16 is fastened by screws 54 to a sensor mounting bracket 70. The bracket 70 is fixed to the lower steering column tube 20, as shown in Fig. 4.

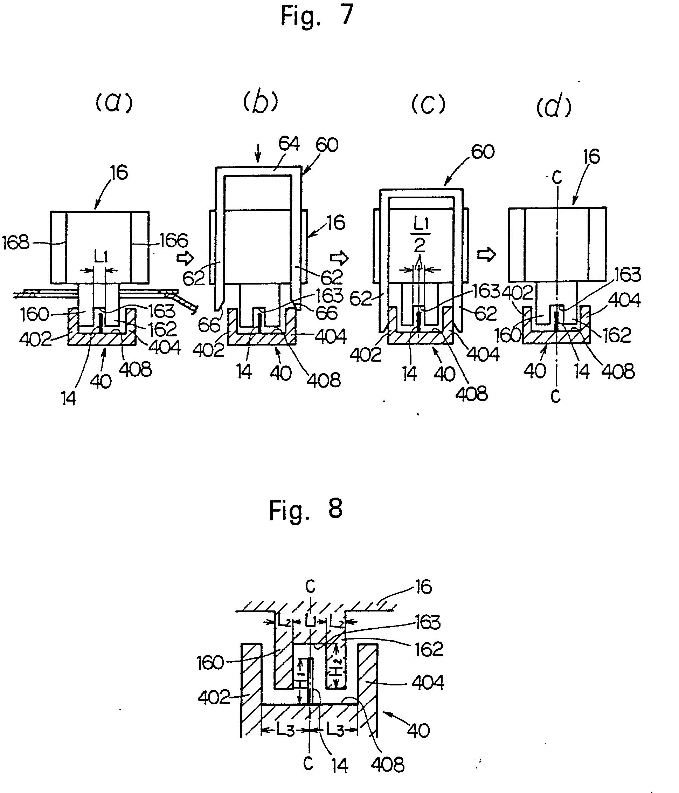

The disc 14 is designed to have a shorter height "$H_1$" than the height of the side walls 402 and 404 of the holder 40 as shown in Fig. 8.

The sensor 16, as shown in Figs. 6 and 7, has a main portion 164 of a hexagonal cross-sectional form, a light emitting element 160, and a light receiving element 162, both of which are secured to the under surface of the main portion 164. The light emitting element 160 and the light receiving element 162 are separated from each other by a distance "$L_1$". The disc 14 is located on the central point of the distance "$L_1$". The sensor 16, as shown in Fig. 6, has front side faces 165, a front intermediate side face 166, rear side faces 167, and a rear intermediate side face 168. The sensor 16 is symmetrical with regard to a central plane "C—C" shown in Fig. 6. The distance between the front intermediate side face 166 and the rear intermediate side face 168 is designed to be substantially the same as that defined between the outer faces of the side walls 402 and 404 of the holder 40. The light emitting element 160 and the light receiving element 162 are provided at the symmetrical positions with regard to a central plane "C—C" through the sensor 16 shown in Fig. 7(d). The light emitting element 160 is designed to have the same thickness as that of the light receiving element 162. There is provided a groove between the light emitting element 160 and the light receiving element 162, whose distance is "$L_1$".

The numeral 60, shown in Figs. 6 and 7, designates a jig for avoiding contact of the thin disc 14 with the light emitting element 160 or the light receiving element 162 when assembling the sensor 16 in the correct position. The jig 60 has a pair of legs 62, and a bridge portion 64 which connects one of the legs 62 with the other leg. The pair of legs 62 extend in parallel with each other. The jig 60 has a cross-sectional form of a U-shape. The distance between the inner faces of the legs 62 is designed to be the same as that defined between the front intermediate side face 166 and the rear intermediate side face 168 of the sensor 16. As the distance between the front intermediate side face and the rear intermediate side face 168 of the sensor 16 is designed to be the same as that defined between the outer faces of the side walls 402 and 404, the distance between the inner faces of the legs 62 is designed to be the same as that defined between the outer faces of the side walls 402 and 404. Each of the legs 62 has a tip end 66 which is inclined outward, and each of the tip ends is oppositely inclined. Each of the legs 62 of the jig 60 is fitted onto the outer face of the side walls 402 or 404 of the holder 40, thereby the jig 60 tightly grips the holder 40.

The references as to the length of the sensor 16 and the holder 40 are shown in Fig. 8. The reference $L_1$, is the distance between the light emitting element 160 and the light receiving element 162. The reference $L_2$, is the width or thickness of the light emitting element 160 and of the light receiving element 162. The reference $L_3$, is the distance between the disc 14 and the side walls 402 or 404 of the holder 40. The height of the disc 14 is indicated by the reference "$H_1$". The light emitting element 160 and the light receiving element 162 project toward the holder 40 by the distance "$H_2$". The embodiment according to the present invention has the following relation:

$$L_1 + L_2 > L_3 \qquad (1)$$

$$H_2 > H_1 \qquad (2)$$

Due to the above relationship (1), even when the outer face of the light emitting element 160 contacts with the inner face of the side wall 402 as shown in Fig. 7(a), the light receiving element 162 does not contact the disc 14. Further, even when the outer face of the light receiving element 162 contacts with the inner face of the side wall 404, the light emitting element 160 does not contact the disc 14.

Due to the above relationship (2), even when the lower ends of the light emitting element 160 and the light receiving element 162 contact the outer surface 408 of the holder 40, the top end of the disc 14 does not contact the under surface 163 of the sensor 16. An apparatus for detecting the angular position and angular velocity of a rotatable member which is in accordance with this relationship (2) is claimed in our European Patent Application No. 0,115,381.

The sensor 16 is assembled into the steering system according to the following procedure:

at first the sensor 16 is held such that the light emitting element 160 contacts the inner face of the side wall 402 of the holder 40, as shown in Fig. 7(a). Next, the jig 60 is inserted from above onto the sensor 16, and the legs 62 of the jig 60 fit into grooves 169 defined in the sensor 16 shown in Fig. 6. One of the inclined low ends of the legs 62 contacts with the outer periphery of the top end of the side wall 404 as shown in Fig. 7(b), thereafter both legs 62 are forced to move downwards while keeping the contact with the outer surfaces of the side walls 402 and 404. The central face "C—C" of the sensor 16 becomes coincident with the plane of the disc 14. The sensor 16 is fastened by the sensor bracket 70 to the lower column tube 20 by screws 54 as shown in Fig. 4. Finally, the jig 60 is removed from the sensor 16.

When the sensor 16 is assembled in the steering column, the disc 14 does not contact the light emitting element 160 or the light receiving element 162. Hence, the disc 14 is not damaged during assembly of the steering system. The sensor 16 can therefore detect accurately the steering angle and the steering angular velocity. Workers can promptly assemble the sensor into the steering column by the use of the jig. Further, the jig can protect the disc from being adversely affected by striking the light emitting element or the light receiving element when the steering column is transferred.

While the present invention has been described in its preferred embodiment, it is to be understood that the invention is not limited thereto, and other embodiments are possible within the scope of the following claims.

## Claims

1. An apparatus for detecting the angular position and angular velocity of a rotatable member (12), comprising a disc (14) mounted on and rotatable with the rotatable member (12), the disc (14) having a number of holes (50) located around the circumference thereof, a fixed member (20), a sensor (16) secured to the fixed member (20) and having positioned on respective opposite sides of the disc, a light emitting means (160) and light receiving means (162) at locations opposite said holes (50) in the disc (14), wherein the disc (14) projects radially from the rotatable member (12) towards the sensor (16) by a distance ($H_1$), and the sensor (16) is provided with extensions in which said light emitting means (160) and said light receiving means (162) are located, respectively, characterized in that there is provided a holder (40) secured to the outer periphery of the steering shaft (12), the holder (40) having the disc (14) secured thereto at a central position along the length of the holder (40), in that the holder (40) comprises a first side wall (402) extending towards the sensor (16), a second side wall (404) extending towards the sensor (16) in a parallel relationship with the first side wall (402), the side walls (402, 404) being spaced apart at a distance ($2L_3$), and a tubular portion (406) which connects the first side wall (402) and the second side wall (404), the disc (14) being secured to the holder (40) centrally of the tubular portion (406), and in that each of said extensions of the sensor (16) have a width ($L_2$), and they are spaced apart by a distance ($L_1$), wherein the following relationship exists:—

$$L_1 + L_2 > L_3$$

2. An apparatus according to Claim 1 for detecting a steering angle and a steering angular velocity of a rotatable part of a steering system mounted on a vehicle, comprising a steering wheel (10), a steering shaft (12) to which the steering wheel (10) is connected at one end thereof, said disc (14) being mounted on and rotatable with the steering shaft (12), and a steering column tube (18) in which the steering shaft (12) is rotatably mounted, said sensor (16) being located with respect to said steering column tube (18).

3. An apparatus according to Claim 2 wherein said steering column tube (18) has secured to a lower end thereof, a lower steering column tube (20) formed with an aperture (52) in its wall and said sensor (16) is detachably mounted on the lower steering column tube (20) so as to project inwardly through said aperture (52) to position said luminescent means and said light receiving means on axially opposite sides of said disc (14).

4. An apparatus according to Claim 2 or Claim 3, further comprising a yoke (24) having a shaft portion (22), an upper portion of which is secured to a lower portion of said steering shaft (12).

5. An apparatus according to Claim 4 wherein a bearing (26) is provided at a position between an outer peripheral portion of the shaft portion (22) of the yoke (24) and an inner surface of the lower steering column tube (20).

6. A method of assembling the sensor (16) of an apparatus as claimed in any of Claims 2—5 in a steering system adjacent the disc (14) thereof, the method comprising the steps of:

contacting an outer surface of one of said extensions of the sensor (16) with an inner surface of a side wall (402, 404) of said holder (40) mounted on the steering shaft (12);

fitting a jig (60) having a pair of legs (62, 62), which are separated by a distance which is the same as that between the outer faces of the side walls (402, 404) of the holder (40), onto the outer surfaces of the sensor (16);

moving the sensor (16) fitted with the jig (60) towards the holder (40); and

removing the jig (60) after the sensor (16) is correctly positioned, in relation to the disc, in the steering system.

**Patentansprüche**

1. Vorrichtung zum Erfassen der Winkelstellung und Winkelgeschwindigkeit eines drehbaren Elementes (12), umfassend eine Scheibe (14), die an dem drehbaren Element (12) angebracht und mit diesem drehbar ist, wobei die Scheibe (14) eine Anzahl von Löchern (50) aufweist, die um ihren Umfang verlaufen, ein feststehendes Element (20), einen Sensor (16), der an dem feststehenden Element (20) angebracht ist und auf jeweils entgegengesetzten Seiten der Scheibe lichtemittierende Mittel (160) und lichtempfangende Mittel (162) in Stellungen gegenüber besagten Löchern (50) in der Scheibe (14) besitzt, worin die Scheibe (14) von dem drehbaren Element (12) zum Sensor (16) hin eine Strecke ($H_1$) radial vorsteht, und der Sensor (16) mit Verlängerungen versehen ist, in denen sich jeweils die lichtemittierenden Mittel (160) und die lichtempfangenden Mittel (162) befinden, dadurch gekennzeichnet, daß ein Halter (40) vorgesehen ist, der an dem Außenumfang der Lenkwelle (12) befestigt ist, wobei der Halter (40) eine Scheibe (14) enthält, die daran in einer Mittelstellung entlang der Länge des Halters (40) befestigt ist, daß der Halter (40) eine erste Seitenwand (402) aufweist, die sich zum Sensor (16) hin erstreckt, eine zweite Seitenwand (404), die sich zum Sensor (16) hin in paralleler Beziehung mit der ersten Seitenwand (402) erstreckt, wobei die Seitenwände (402, 404) mit einem Abstand ($2L_3$) räumlich getrennt sind, sowie einen röhrenförmigen Teil (406), der die erste Seitenwand (402) und die zweite Seitenwand (404) verbindet, wobei die Scheibe (14) an dem Halter (40) mittig von dem röhrenförmigen Teil (406) befestigt ist, und daß jede dieser Verlängerungen des Sensors (16) eine Breite ($L_2$) aufweist, und die Verlängerungen mit einem Abstand ($L_1$) räumlich getrennt sind, worin die folgende Beziehung besteht:—

$$L_1 + L_2 > L_3$$

2. Vorrichtung nach Anspruch 1 zum Erfassen eines Lenkwinkels und einer Lenkwinkelgeschwindigkeit eines drehbaren Teiles einer in einem Fahrzeug montierten Lenkanordnung, umfassend ein Lenkrad (10), eine Lenkwelle (12), mit deren einem Ende das Lenkrad (10) verbunden ist, wobei besagte Scheibe (14) an der Lenkwelle (12) angebracht und mit dieser drehbar ist, sowie ein Lenksäulenrohr (18), in dem die Lenkwelle (12) drehbar angebracht ist, wobei jener Sensor (16) in Beziehung zu dem Lenksäulenrohr (18) angeordnet ist.

3. Vorrichtung nach Anspruch 2, worin an einem unteren Ende des Lenksäulenrohres (18) ein unteres Lenksäulenrohr (20) befestigt ist, das mit einer Öffnung (52) in seiner Wand geformt ist, und besagter Sensor (16) abnehmbar an dem unteren Lenksäulenrohr (20) angebracht ist, solcherart, daß er durch diese Öffnung (52) nach innen ragt, um jene lumineszierenden Mittel und jene lichtempfangenden Mittel auf axial entgegengesetzten Seiten der Scheibe (14) in Stellung zu bringen.

4. Vorrichtung nach Anspruch 2 oder Anspruch 3, weiterhin umfassend eine Gabel (24) mit einem Wellenteil (22), dessen oberer Teil an einem unteren Teil besagter Lenkwelle (12) befestigt ist.

5. Vorrichtung nach Anspruch 4, worin ein Lager (26) in einer Stellung zwischen einem Außenumfangsteil des Wellenteiles (22) der Gabel (24) und einer Innenfläche des unteren Lenksäulenrohres (20) vorgesehen ist.

6. Verfahren, um den Sensor (16) einer Vorrichtung nach einem der Ansprüche 2—5 in einer Lenkanordnung angrenzend an deren Scheibe (14) zu montieren, wobei das Verfahren die Schritte umfaßt:

Herstellen einer Berührung zwischen einer Außenfläche einer jener Verlängerungen des Sensors (16) und einer Innenfläche einer Seitenwand (402, 404) des an der Lenkwelle (12) angebrachten Halters (40);

Anbringen einer Aufspannvorrichtung (60) auf den Außenflächen des Sensors (16), wobei die Aufspannvorrichtung ein Schenkelpaar (62, 62) besitzt, das durch einen Abstand getrennt ist, der gleich ist wie der zwischen den Aussenflächen der Seitenwände (402, 404) des Halters (40);

Bewegen des mit der Aufspannvorrichtung (60) versehenen Sensors (16) in Richtung auf den Halter (40); und

Entfernen der Aufspannvorrichtung (60), nachdem der Sensor (16) in Beziehung zu der Scheibe korrekt in Stellung in der Lenkanordnung gebracht ist.

**Revendications**

1. Un appareil pour détecter la position et la vitesse angulaires d'un organe rotatif (12) comprenant un disque (14) monté sur l'organe rotatif (12) et susceptible de tourner avec lui, le disque (14) comportant un certain nombre de trous (50) situés sur sa circonférence, un organe fixe (20), un capteur fixé à cet organe fixe (20) et présentant disposé de part et d'autre du disque, des moyens d'émission luminuex (160) et des moyens de réception de lumière (162) situés en des emplacements opposés auxdits trous (50) dans le disque (14), lequel disque (14) s'étend radialement depuis l'organe rotatif (12) en direction du capteur (16) sur une distance ($H_1$) et le capteur (16) est pourvu d'extensions dans lesquelles lesdits moyens d'émission lumineux (160) et lesdits moyens de réception lumineux (162) sont respectivement, logés, caractérisé en ce qu'il comporte une attache (40) est fixée à la périphérie extérieure de l'arbre de direction (12), le disque (14) étant fixé à l'attache (40) en une partie centrale le long de l'attache (40) et en ce que l'attache (40) comprend une première paroi latérale (402) dirigée vers le capteur (16), une seconde paroi latérale (404) dirigée également vers le capteur (16) et parallèle à la première paroi latérale (402), les parois latérales (402, 404) étant espacées l'une de l'autre d'une distance (2L$_3$), et comprend une portion tubulaire (406) qui relie la première paroi latérale (402) à la seconde paroi latérale (404), le disque (14) étant fixé à l'attache (40) au centre de la portion tubulaire (406) et en ce que chacun desdits prolongements ou extensions du capteur (16) a une certaine largeur (L$_2$) et sont espacées l'une de l'autre d'une distance (L$_1$) tout en satisfaisant la relation suivante:

$$L_1 + L_2 > L_3$$

2. Un appareil selon la revendication 1, pour la détection d'un angle de direction et de la vitesse angulaire de direction d'une partie rotative d'un système de direction monté sur un véhicule, comprenant un volant (10), un arbre de direction (12) à une extrémité duquel le volant de direction (10) est attaché, ledit disque (14) étant monté sur l'arbre de direction (12) et étant susceptible de tourner avec lui et une colonne tubulaire de direction (18) dans laquelle l'arbre de direction (12) est monté en rotation, ledit capteur (16) étant positionné par rapport à ladite colonne tubulaire de direction (18).

3. Un appareil selon la revendication 2, dans lequel la colonne tubulaire de direction (18) est fixée à son extrémité inférieure à une partie inférieure de la colonne tubulaire de direction (20), dans la paroi de laquelle une ouverture est pratiquée et ledit capteur (16) est monté de façon amovible sur la partie inférieure de la colonne tubulaire de direction (20) de façon à s'avancer vers l'intérieur à travers ladite ouverture (52) pour mettre en position lesdits moyens émetteurs de lumière et lesdits moyens récepteurs de lumière sur des côtés axialement opposés du disque (14).

4. Un appareil selon la revendication 2 ou la revendication 3, comprenant un élément d'étrier (24) ayant une portion d'arbre (22) dont la partie supérieure est fixée à la partie inférieure dudit arbre de direction (12).

5. Un appareil selon la revendication 4, dans lequel un appui (26) est prévu en un endroit entre la partie de la périphérie extérieure de la portion d'arbre (22) de l'élément d'étrier (24) et une surface intérieure de la partie inférieure de la colonne tubulaire de direction (20).

6. Une méthode de montage du capteur (16) d'un appareil tel que décrit dans les revendications 2 à 5, à l'intérieur d'un système de direction comportant le disque (14), la méthode comprenant les étapes suivantes:

—mise en contact de la surface extérieure de l'une desdites extensions du capteur (16) avec la surface intérieure d'une paroi latérale (402, 404) de ladite attache (40) montée sur l'arbre de direction (12);

—ajustage sur les surfaces externes du capteur (16) d'un gabarit (60) pourvu d'une paire de jambes (62, 62) qui sont séparées d'une distance identique à celle entre les faces extérieures des parois latérales (402, 404) de l'attache (40);

—déplacement du capteur (16) équipé du gabarit (60) vers l'attache (40); et

—enlèvement du gabarit (60) après positionnement correct du capteur (16) par rapport au disque, du système de direction.

Fig. 1

10

12

Fig. 2

16

12

14

Fig. 3

Fig. 4

# Fig. 5

# Fig. 6

# Fig. 7

(a)        (b)        (c)        (d)

# Fig. 8